# EUROPEAN PATENT APPLICATION

(11) **EP 2 735 625 A1**
(43) Date of publication of application: **28.05.2014**
(21) Application number: 13191163.8
(22) Date of filing: 31.10.2013
(51) Int. Cl.: C23C 16/44, C23C 16/455, H01L 31/00, H01L 21/00, H01L 21/67

(54) **A device for manufacturing a film used for a solar cell**

(30) Priority: 27.11.2012 KR 20120135546
(71) Applicant: Samsung SDI Co., Ltd., Yongin-si, Gyeonggi-do (KR)
(72) Inventor: Kim, In-Ki, Gyeonggi-do (KR); Ahn, Dong-Gi, Gyeonggi-do (KR); Kim, Byoung-Dong, Gyeonggi-do (KR); Lee, Seung-Jin, Gyeonggi-do (KR); Kishimoto, Katsushi, Gyeonggi-do (KR)
(74) Representative: Walaski, Jan Filip

(57) **Abstract**

A film forming device for a solar cell comprises a first chamber, a second chamber in the first chamber and configured to receive a substrate, a heating device between the first chamber and the second chamber and a pressure control device connected to the first and second chambers by one or more exhaust lines and configured to control a pressure of the first chamber and the second chamber.

## Description

The described technology relates generally to a film forming device for a solar cell. More particularly, the described technology relates generally to a chamber for forming a film.

A thin film solar cell, as one kind of solar cell, uses a chamber to form a constituent element such as a light absorbing layer.

For example, in a copper-indium-gallium-selenide (hereafter referred to as CIGS) solar cell, the light absorbing layer may be formed through heat treatment at a high temperature after a substrate formed with a precursor is inserted inside a chamber.

However, there are many problems to manage when a chamber is used to manufacture a thin film solar cell such as a CIGS (CuInGaSe2) solar cell.

Aspects of embodiments of the present invention are directed toward a film forming device for a solar cell including a structure that prevents or reduces damage to a chamber by controlling the internal pressure and the external pressure of the chamber.

Additionally, aspects of embodiments of the present invention are directed toward a film forming device for a solar cell including a chamber that is light and efficiently uses an inner space.

A film forming device for a solar cell according to an exemplary embodiment includes: a chamber including: a first chamber; a second chamber in the first chamber and configured to receive a substrate; a heating device between the first chamber and the second chamber; and a pressure control device connected to the chamber by an exhaust line and configured to control a pressure of the first chamber and the second chamber.

The exhaust line may be connected to a first exhaust port located at the first chamber, and the second chamber may include a second exhaust port facing the first exhaust port.

The exhaust line may include an exhaust line body connected to a pump, and a first exhaust line and a second exhaust line respectively extended from one end of the exhaust line body, wherein the first exhaust line may be connected to a space between the first chamber and the second chamber, and the second exhaust line may be connected to a hollow portion of the second chamber.

A valve in the exhaust line body may be further included.

A first valve in the first exhaust line and a second valve in the second exhaust line may be further included.

The exhaust line may include: a first exhaust line connected to a space positioned between the first chamber and the second chamber and connected to a first pump; and a second exhaust line connected to a hollow portion of the second chamber and connected to a second pump.

A first valve in the first exhaust line and a second valve in the second exhaust line may be further included.

A safety apparatus between the first exhaust line and the second exhaust line and configured to fluidly connect the first exhaust line and the second exhaust line may be further included.

The second chamber may include a plurality of chambers.

According to aspects of an exemplary embodiment, a pressure difference between the outside and the inside of the chamber may be minimized or reduced.

Also, aspects of embodiments of the present invention are directed toward providing a film forming device for a solar cell including a light weight chamber (e.g., a chamber having reduced weight).

Further, aspects of embodiments of the present invention are directed toward providing a film forming device for a solar cell including a chamber having high design freedom (e.g., a chamber having a large number of design possibilities).

The accompanying drawings, together with the specification, illustrate exemplary embodiments of the present invention, and, together with the description, serve to explain the principles of the present invention.
FIG. 1 is an exploded perspective view of a film forming device for a solar cell according to a first exemplary embodiment of the present invention.
FIG. 2 is a cross-sectional view taken along the line II-II of FIG. 1.
FIG. 3 is a cross-sectional view of a film forming device of a solar cell according to a second exemplary embodiment of the present invention.
FIG. 4 is a cross-sectional view of a film forming device of a solar cell according to an exemplary variation of the second exemplary embodiment of the present invention.
FIG. 5 is a cross-sectional view of a film forming device of a solar cell according to a third exemplary embodiment of the present invention.
FIG. 6 is a cross-sectional view of a film forming device of a solar cell according to an exemplary variation of the second exemplary embodiment of the present invention.

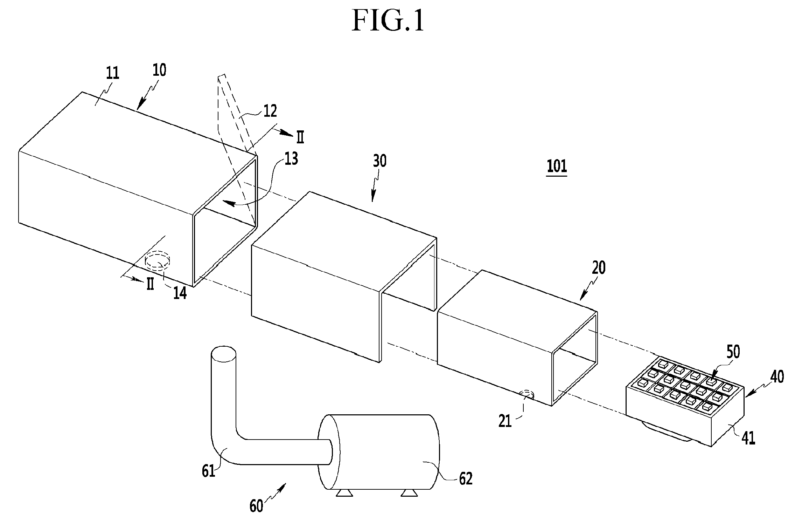

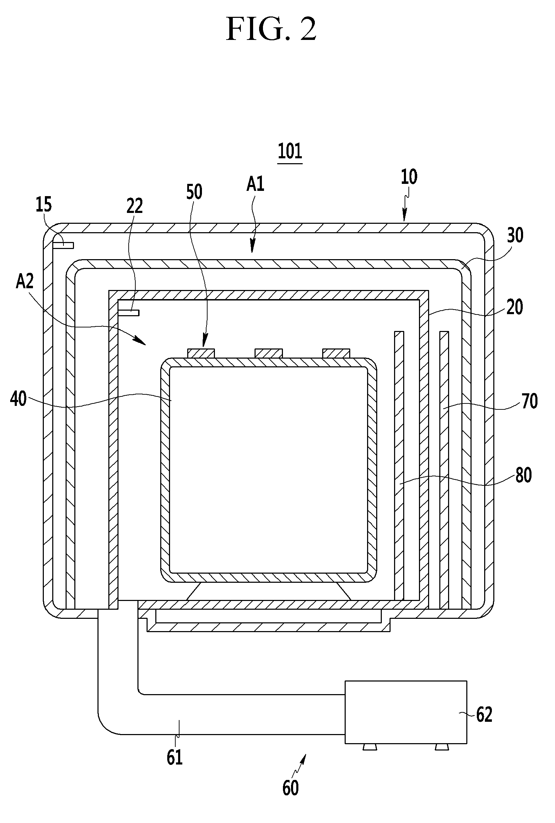

Referring to FIG. 1 and FIG. 2, a film forming device 101 for a solar cell according to the present exemplary embodiment includes a chamber including a first chamber 10 and a second chamber 20, a heating device 30 between the first chamber 10 and the second chamber 20, a substrate loading device 40 configured to receive a substrate 50 and received by the second chamber 20 (e.g., the substrate loading device 40 may be housed in the second chamber 20), and a pressure control device 60 connected to the chamber.

Here, the film forming device 101 according to the present exemplary embodiment may form a thin layer or a thick layer on the substrate 50. However, for convenience, forming the thin film on the substrate 50 will be described.

The first chamber 10 according to the present exemplary embodiment may include a body 11 having a hollow portion, a door 12, and an opening 13 that is opened and closed by the door 12 (e.g., covered or uncovered by the door 12).

Accordingly, the first chamber 10 according to the present exemplary embodiment may be closed and sealed at the opening 13 such that the first chamber 10 may be operated in a completely (or substantially completely) closed and sealed state without (or substantially without) inflow of external air.

The body 11 may include a pair of side surfaces (e.g., side surfaces that are opposite to one another) and surfaces connecting the side surfaces, and a cross-sectional shape of the body 11 may be quadrangular (or substantially quadrangular), for example rectangular. In some embodiments, the cross-sectional shape of the body 11 may deviate from a quadrangular shape and still be substantially quadrangular, for example as shown in the cross-sectional view of FIG. 2.

However, the cross-sectional shape of the body 11 is not limited to quadrangular, and it may be one of a circular, an oval, or a regular hexagonal cross-sectional shape. The cross-sectional shape of the body 11 may deviate from a circular, an oval, or a regular hexagonal cross-sectional shape and still have a substantially circular, oval, or regular hexagonal shape.

As shown in FIG. 2, the first pressure sensor 15 is installed (e.g., located) inside the first chamber for measuring an internal pressure of the first chamber 10.

Accordingly, in the present exemplary embodiment, the second chamber 20 is received by a hollow portion of the first chamber 10 (e.g., the second chamber 20 may be housed in the first chamber 10), and the substrate loading device 40, which may be mounted with the substrate 50, may be received by the hollow portion of the second chamber 20.

Also, a second pressure sensor 22 is installed (e.g., located) inside the second chamber 20, according to the present exemplary embodiment, for measuring the pressure of the hollow portion of the second chamber 20.

In more detail, a first pressure sensor 15 and the second pressure sensor 22 according to the present exemplary embodiment are connected to a control device such that they are configured to transmit the pressure of the first chamber 10 and the pressure of the second chamber 20 to the control device.

Also, according to the present exemplary embodiment, a first space A1 is the whole space between the first chamber 10 and the second chamber 20, and a second space A2 includes the hollow portion of the second chamber 20 i.e. the space inside the second chamber 20.

Accordingly, the first pressure sensor 15 according to the present exemplary embodiment may measure the pressure of the first space A1, and the second pressure sensor 22 may measure the pressure of the second space A2.

Also, a first gas spray device 70 may be installed (e.g., located) at the first space A1 between the first chamber 10 and the second chamber 20, and a second gas spray device 80 may be installed (e.g., located) at the second space A2.

In the present embodiment, the first space A1 and the second space A2 are in a vacuum state (e.g., a partial vacuum state) and are then filled (e.g., partially filled) with copper (Cu), indium (In), gallium (Ga), and selenium (Se) vapour by the first gas spray (supply) device 70 and the second gas spray device 80. For example, the second space A2 may be in a vacuum state (e.g., a high vacuum or ultra-high vacuum state) and Cu, In, Ga and selenium may be introduced into the second space A2 by the second gas spray device 80.

The first chamber 10 and the second chamber 20 according to the present exemplary embodiment may be made of a metal, but the present invention is not limited thereto. For example, the first chamber 10 and the second chamber 20 may be made of other suitable materials, such as quartz.

The first chamber 10 and the second chamber 20 according to the present exemplary embodiment may be connected to the pressure control device 60.

The pressure control device 60 according to the present exemplary embodiment may include an exhaust line 61 (e.g., an exhaust pipe) and a pump 62 (e.g., a vacuum pump).

One end of the exhaust line 61 of the pressure control device 60 may be connected to a first exhaust port 14 formed (e.g., located) at the first chamber 10. For example, the exhaust line 61 of the pressure control device 60 may be formed (e.g., located) at the first exhaust port 14 formed at the first chamber 10, and at a second exhaust port 21 facing the first exhaust port 14 formed (e.g., located) at the second chamber 20.

In more detail, the first exhaust port 14 formed (e.g., located) at the first chamber 10 according to the present exemplary embodiment may be positioned (e.g., located) at the first space A1 between the first chamber 10 and the second chamber 20, and the second exhaust port 21 formed (e.g., located) at the second chamber 20 may be positioned (e.g., located) at the second space A2 including the hollow portion of the second chamber 20.

Accordingly, the exhaust line 61 of the pressure control device 60 according to the present exemplary embodiment may be fluidly connected to the first space A1 and the second space A2 through the first exhaust port 14 and the second exhaust port 21.

According to the present exemplary embodiment, the pressure values measured at the first and second pressure sensors 15 and 22 are transmitted to the control device, thereby providing the control device with input for operating the pump 62 of the pressure control device 60 when the pressure of the first space A1 and the pressure of the second space A2 are different from one another so that the pressure of the first space A1 and the pressure of the second space A2 can be made to be the same (or substantially the same).

For example, the second space A2 including the hollow portion of the first chamber 20 according to the present exemplary embodiment enters a vacuum state such that the substrate loading device 40 mounted with the substrate 50 is loaded in the second space A2 in the state in which the internal pressure of the second space A2 is 0 Torr (or about 0 Torr).

However, if the heating device 30 installed (e.g., located) at the first space A1 is operated, according to the Ideal Gas Equation, the pressure value of the first space A1 is raised, and then the pressure value of the first space A1 and the pressure value of the second space A2 will be different from one another.

At this time, the first pressure sensor 15 and the second pressure sensor 22 measure and transmit the pressure values of the first space A1 and the second space A2, respectively, to the control device, and the control device operates the pump 62 such that the air of the first space A1 and the second space A2 may be exhausted (e.g., evacuated) outside the first chamber 10 and the second chamber 20 through the exhaust line 61.

Accordingly, according to the present exemplary embodiment, it is possible for the pressure of the first space A1 and the second space A2 to be maintained to be almost the same (e.g., substantially the same).

Resultantly, according to aspects of the present exemplary embodiment, it is possible to minimize or reduce the pressure difference between the second space A2 inside the second chamber 20 and the first space A1 outside the second chamber 20.

Accordingly, according to aspects of embodiments of the present invention, deformation or damage to the second chamber 20 due to a pressure difference between the first space A1 and the second space A2 may be prevented or reduced.

According to other aspects of embodiments of the present invention, since the pressure difference is not generated (e.g., is not present or is negligible) between the outside and the inside of the second chamber 20 (e.g., the difference in pressure between the outside and the inside of the second chamber 20 is minimized or reduced), the thickness and the weight of the second chamber 20 can be reduced (as compared to embodiments in which a difference in pressure between the outside and the inside of the second chamber 20 is present), and the weight of the second chamber 20 becomes light.

According to embodiments of the present invention, the cross-sectional shape of the second chamber 20 is not limited to a circular or an oval shape, and it may be quadrangular such that design freedom of the second chamber 20 may be improved or enhanced.

Accordingly, it is possible to fabricate a quadrangular chamber which, in comparison to a chamber having a cross-section of a circular or oval shape, has reduced gas consumption and is capable of forming large numbers of thin films on many substrates.

For example, the chamber according to the present invention is not limited to the first and second chambers 10 and 20, and the chamber may include three or more chambers.

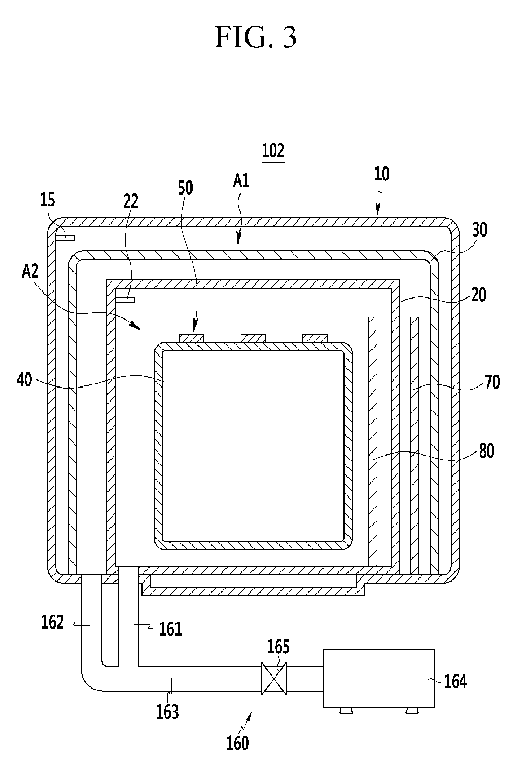

FIG. 3 is a cross-sectional view of a film forming device for a solar cell according to a second exemplary embodiment of the present invention.

Referring to FIG. 3, a film forming device 102 for a solar cell according to the present exemplary embodiment includes the same (or substantially the same) constitution as the film forming device 101 according to the first exemplary embodiment of the present invention, except for a pressure control device 160.

Accordingly, the detailed description for the components that are the same (or substantially the same) as those of the film forming device 101 according to the first exemplary embodiment of the present invention is omitted here.

Referring to FIG. 3, the pressure control device 160 according to the present exemplary embodiment may include an exhaust line body 163, a first exhaust line 162, a second exhaust line 161, a pump 164, and a valve 165.

In more detail, one end of the exhaust line body 163 is connected to the pump 164, and the first exhaust line 162 and the second exhaust line 161extended from the other end of the exhaust line body 163 may be respectively connected to the first chamber 10 and the second chamber 20.

According to the present exemplary embodiment, the first space A1 and the second space A2 are separated from one another such that copper (Cu), indium (In), gallium (Ga), selenium (Se), etc. (for example, Cu, In, Ga, and Se in a vapour state), filled (e.g., partially filled or present) in the second space A2, do not flow into the first space A1.

Accordingly, corrosion of an outer side wall of the first chamber 10, which may be made of stainless steel, due to exposure to copper (Cu), indium (In), gallium (Ga), and/or selenium (Se) may be prevented or reduced.

According to the present exemplary embodiment, the pressure of the first space A1 positioned (e.g., located) outside of the second chamber 20 may be controlled through the first exhaust line 162, and the pressure of the second space A2 positioned (e.g., located) inside the second chamber 20 may be controlled through the second exhaust line 161.

In more detail, the pressure values measured at the first and second pressure sensors 15 and 22 are transmitted to the control device, thereby providing the control device with input for operating the pump 164 of the pressure control device 160 when the pressure of the first space A1 and the pressure of the second space A2 are different from one another so that the pressure of the first space A1 and the pressure of the second space A2 can be made to be the same (or substantially the same).

For example, the second space A2 including the hollow portion of the first chamber 20 according to the present exemplary embodiment enters a vacuum state such that the substrate loading device 40 mounted with the substrate 50 is loaded in the second space A2 in the state in which the internal pressure of the second space A2 is 0 Torr (or about 0 Torr).

However, if the heating device 30 installed (e.g., located) at the first space A1 is operated, the pressure value of the first space A1 and the pressure value of the second space A2 will be different from one another.

At this time, the first pressure sensor 15 and the second pressure sensor 22 measure and transmit the pressure values of the first space A1 and the second space A2, respectively, to the control device, and the control device operates the pump 164 such that the air of the first space A1 and the second space A2 may be exhausted (e.g., evacuated) outside the first chamber 10 and the second chamber 20 through the first exhaust line 162 and the second exhaust line 161, respectively.

Accordingly, according to the present exemplary embodiment, it is possible for the pressure of the first space A1 and the second space A2 to be maintained to be almost the same (or substantially the same).

According to the present exemplary embodiment, the exhaust line body 163 further includes a valve 165 controlling the amount of air exhausted from the first exhaust line 162 and the second exhaust line 161.

Here, the valve 165 according to the present exemplary embodiment may be a gate valve or an APC valve.

Resultantly, according to aspects of embodiments of the present exemplary embodiment, it is possible to minimize or reduce the pressure difference between the second space A2 inside the second chamber 20 and the first space A1 outside the second chamber 20.

Accordingly, according to aspects of embodiments of the present invention, deformation or damage of the second chamber 20 due to a pressure difference between the first space A1 and the second space A2 may be prevented or reduced.

According to other aspects of embodiments of the present invention, since the pressure difference is not generated (e.g., is not present or is negligible) between the outside and the inside of the second chamber 20 (e.g., the difference in pressure between the outside and the inside of the second chamber 20 is minimized or reduced), the thickness and the weight of the second chamber 20 can be reduced (as compared to embodiments in which a difference in pressure between the outside and the inside of the second chamber 20 is present), and the weight of the second chamber 20 becomes light.

According to embodiments of the invention, the cross-section of the second chamber 20 is not limited to a circular or an oval shape, and it may be quadrangular such that design freedom of the second chamber 20 may be improved or enhanced.

Accordingly, it is possible to fabricate a quadrangular chamber which, in comparison to a chamber having a cross-section of a circular or an oval shape, has reduced gas consumption and is capable of forming a large number of thin films on many substrates.

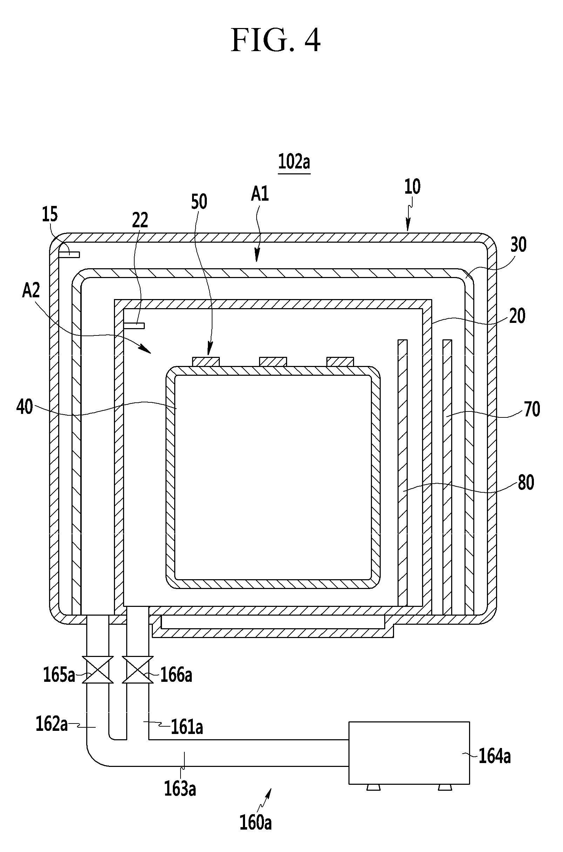

FIG. 4 is a cross-sectional view of a film forming device for a solar cell according to an exemplary variation of the second exemplary embodiment of the present invention.

Referring to FIG. 4, a film forming device 102a for a solar cell according to the present exemplary embodiment includes the same (or substantially the same) constitution as the film forming device 102 according to the second exemplary embodiment of the present invention, except for a pressure control device 160a.

Accordingly, the detailed description for the components that are the same (or substantially the same) as those of the film forming device 102 according to the second exemplary embodiment of the present invention is omitted here.

Referring to FIG. 4, the pressure control device 160a according to the present exemplary embodiment may include an exhaust line body 163a, a first exhaust line 162a, a second exhaust line 161a, a pump 164a, a first valve 165a, and a second valve 166a.

Here, the pressure control device 160a according to the present exemplary embodiment has the same (or substantially the same) constitution as the pressure control device 160 according to the second exemplary embodiment of the present invention, except for the first and second valves 165a and 166a, such that the detailed description of the components that are the same (or substantially the same) as those of the second exemplary embodiment is omitted here.

As shown in FIG. 4, the first valve 165a according to the present exemplary embodiment may be coupled to the first exhaust line 162a, and the second valve 166a may be coupled to the second exhaust line 161a.

According to the present exemplary embodiment, the pressure of the first space A1 and the pressure of the second space A2 may be separately controlled.

Here, the first and second valves 165a and 166a according to the present exemplary embodiment may be gate valves or APC valves.

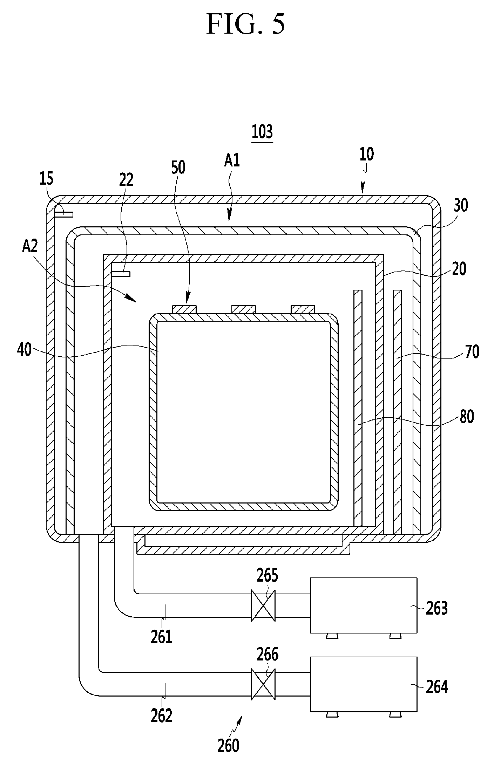

FIG. 5 is a cross-sectional view of a film forming device for a solar cell according to a third exemplary embodiment of the present invention.

Referring to FIG. 5, a film forming device 103 for a solar cell according to the present exemplary embodiment has the same (or substantially the same) constitution as the film forming device 101 according to the first exemplary embodiment of the present invention, except for a pressure control device 260.

Accordingly, the detailed description of the components that are the same (or substantially the same) as those of the film forming device 101 according to the first exemplary embodiment of the present invention is omitted here.

Referring to FIG. 5, the pressure control device 103 according to the present exemplary embodiment may include a first exhaust line 262, a second exhaust line 261, a first pump 264, a second pump 263, a first valve 266, and a second valve 265.

In more detail, the first exhaust line 262 according to the present exemplary embodiment may be connected to the first space A1, the first valve 266 may be installed (e.g., located) at the first exhaust line 262, and one end of the first exhaust line 262 may be connected to the first pump 264.

The second exhaust line 261 according to the present exemplary embodiment may be connected to the second space A2, the second valve 265 may be installed (e.g., located) at the second exhaust line 261, and one end of the second exhaust line 261 may be connected to the second pump 263.

Here, the first and second valves 265 and 266 according to the present exemplary embodiment may be gate valves or APC valves.

According to the present exemplary embodiment, the pressure of the first space A1 and the pressure of the second space A2 may be separately controlled.

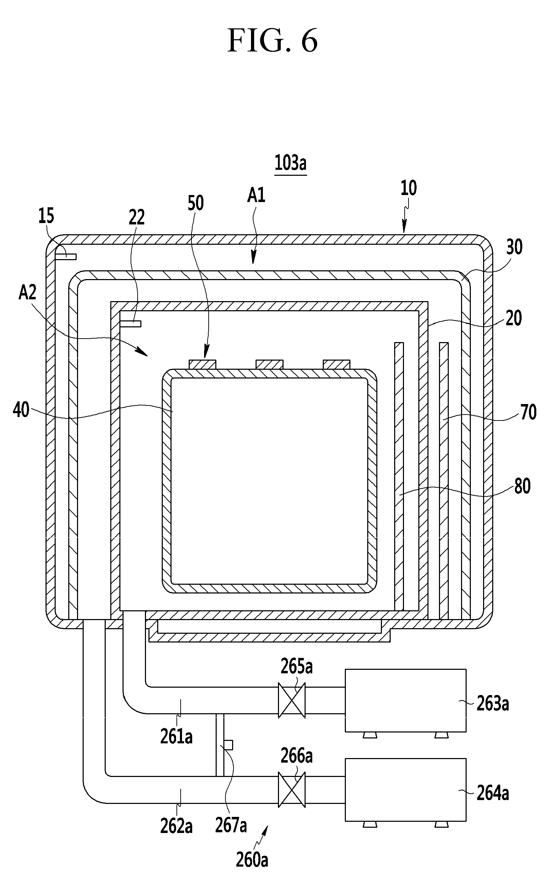

FIG. 6 is a cross-sectional view of a film forming device for a solar cell according to an exemplary variation according to the third exemplary embodiment of the present invention.

Referring to FIG. 6, a film forming device 103a for a solar cell according to the present exemplary embodiment has the same (or substantially the same) constitution as the film forming device 103 according to the third exemplary embodiment of the present invention, except for a pressure control device 260a, such that detailed description of the components that are the same (or substantially the same) as those of the film forming device 103 is omitted here.

Referring to FIG. 6, the pressure control device 260a according to the present exemplary embodiment may include a first exhaust line 262a, a second exhaust line 261a, a first pump 264a, a second pump 263a, a first valve 266a, a second valve 265a, and a safety apparatus 267a.

The pressure control device 260a according to the present exemplary embodiment is the same (or substantially the same) as the pressure control device 260a according to the third exemplary embodiment of the present invention, except for the safety apparatus 267a.

Accordingly, detailed description of the components that are the same (or substantially the same) as those of the third exemplary embodiment of the present invention is omitted here.

Referring to FIG. 6, the safety apparatus 267a according to the present exemplary embodiment is installed (e.g., located) between the first exhaust line 262a and the second exhaust line 261a, thereby fluidly connecting the first exhaust line 262a and the second exhaust line 261a.

For example, the safety apparatus 267a according to the present exemplary embodiment may be configured to burst when the pressure difference between the first exhaust line 262a and the second exhaust line 261a is more than a predetermined (or preselected) pressure difference, such that the first exhaust line 262a and the second exhaust line 261a may be fluidly connected.

Accordingly, by the safety apparatus 267a according to the present exemplary embodiment, the pressure difference between the first exhaust line 262a and the second exhaust line 261a may be reduced.

While this invention has been described in connection with what are presently considered to be practical exemplary embodiments, it is to be understood that the invention is not limited to the disclosed embodiments, but, on the contrary, is intended to cover various modifications and equivalent arrangements included within the scope of the appended claims.

## Claims

1. A film forming device for a solar cell comprising:
a first chamber;
a second chamber in the first chamber and configured to receive a substrate;
a heating device between the first chamber and the second chamber; and
a pressure control device connected to the first and second chambers and configured to control a pressure of the first chamber and the second chamber.

2. The film forming device of claim 1, further comprising an exhaust line connected to a first exhaust port located at the first chamber, and a second exhaust port facing the first exhaust port at the second chamber.

3. The film forming device of claim 1, wherein the pressure control device comprises an exhaust line body connected to a pump, and a first exhaust line and a second exhaust line respectively extending from one end of the exhaust line body,
wherein the first exhaust line is connected to a space between the first chamber and the second chamber, and
the second exhaust line is connected to the inside of the second chamber.

4. The film forming device of claim 3, further comprising a valve in the exhaust line body.

5. The film forming device of claim 3 or 4, further comprising:
a first valve in the first exhaust line; and
a second valve in the second exhaust line.

6. The film forming device of claim 1, wherein the pressure control device comprises:
a first exhaust line connected to a space between the first chamber and the second chamber and connected to a first pump; and
a second exhaust line connected to the inside of the second chamber and connected to a second pump.

7. The film forming device of claim 6, further comprising:
a first valve in the first exhaust line; and
a second valve in the second exhaust line.

8. The film forming device of claim 7, further comprising
a safety apparatus between the first exhaust line and the second exhaust line and configured to fluidly connect the first exhaust line and the second exhaust line.

9. The film forming device of any one of the preceding claims, wherein
the second chamber comprises a plurality of chambers.
